# EUROPEAN PATENT SPECIFICATION

(11) **EP 4 471 465 B1**
(45) Date of publication and mention of the grant of the patent: **23.09.2026**
(21) Application number: 24177498.3
(22) Date of filing: 22.05.2024
(51) Int. Cl.: G02B 1/11, G02B 1/14

(54) **COVER WINDOW AND DISPLAY DEVICE INCLUDING THE SAME**
ABDECKFENSTER UND ANZEIGEVORRICHTUNG DAMIT
FENÊTRE DE COUVERTURE ET DISPOSITIF D'AFFICHAGE LA COMPRENANT

(30) Priority: 31.05.2023 KR 20230069857
(43) Date of publication of application: 04.12.2024
(73) Proprietor: LG Display Co., Ltd., Seoul 07336 (KR)
(72) Inventor: Oh, Yuseok, 10845 Paju-si (KR); Lee, Ju-Yeob, 10845 Paju-si (KR); Lee, Euijun, 10845 Paju-si (KR); Kim, Yongsoo, 10845 Paju-si (KR); Park, Eungchul, 10845 Paju-si (KR)
(74) Representative: Ter Meer Steinmeister & Partner

(56) References cited:
- EP-A1- 4 134 409
- US-A1- 2020 410 208
- US-B2- 8 358 467

## Description

### BACKGROUND

### Field

The present disclosure relates to a cover window that has excellent surface hardness and scratch resistance, is resistant to external shocks, and can maintain light efficiency, and a display device including the same.

### Description of Related Art

A display device is applied to various electronic devices such as TVs, mobile phones, laptops, and tablets. To this end, research is continuing to develop the display device that is thinner, lighter, and has lower power consumption.

The display device may include one of a liquid crystal display device (LCD), a plasma display device (PDP), a field emission display device (FED), an organic light-emitting display device (OLED), and a micro LED (Micro Light Emitting Diode) display device.

Recently, the demand for a flexible display device that may be bent flexibly and maintain performance in a bent state is increasing. The flexible display device has the advantage of significantly reducing a volume of the display device by rolling or folding the display device as needed. Accordingly, research on the flexible display device is being actively conducted.

As the research on the flexible display device is conducted, research on a cover window applied to the flexible display device is also increasing. The cover window serves to protect a screen of the display device from external influences. Additionally, the cover window serves to convey the screen displayed on the display device to the user.

Accordingly, interest in a cover window with high hardness at which the cover window can withstand scratches, high strength at which breakage of the cover window can be prevented, and having optical properties is increasing.
US 8 358 467 B2 discloses an article which may be used as a cover plate, wherein a anti-reflection coating is disposed on a substrate and covered by a hydrophobic layer with anti-fingerprint characteristics.
EP 4 134 409 A1 discloses a protective film that may be attached to a display surface and which includes a base film layer, an anti-reflective layer and an anti-fingerprint layer.
US 2020/410208 A1 discloses a display device with a flexible cover lens assembly including an anti-reflectance layer and an anti-fingerprint layer.

### SUMMARY

An object of the present disclosure is to provide a cover window that has excellent surface hardness and/or resistance to scratches, and thus is strong against external shock.

A further object of the present disclosure is to provide a cover window that can maintain light efficiency, and a display device including the same.

Furthermore, an object of the present disclosure is to provide a cover window including an anti-reflection layer in which cracks does not occur even when the cover window is repeatedly folded or rolled up, and a display device including the same.

The object is solved by the features of claim 1. Preferred embodiments are given in the dependent claims.

A cover window according to one embodiment of the present disclosure includes a base substrate; a hard coating layer disposed on top of the base substrate; an anti-reflection layer disposed on top of the hard coating layer and including a flexible film; and an anti-fingerprint layer disposed on top of the anti-reflection layer.

In the following optional feature are provided, which might be combined with the cover window or the display device having such cover window, independently or in combination or sub combination.

According to the invention, the flexible film is disposed under the anti-fingerprint layer.

According to the invention, the flexible film constitutes a top layer of the anti-reflection layer.

In one or more embodiments, one surface of the flexible film may be in contact with the hard coating layer.

In one or more embodiments, the flexible film may include an organic material.

In one or more embodiments, the organic material may include a polymer compound.

In one or more embodiments, the polymer compound may contain a silicone-based polymer and a functional organic-inorganic silane compound.

In one or more embodiments, the organic material may include a mixture of urethane and at least one of silane, low-concentration silane, high-concentration silane, or a silane compound.

According to the invention, the anti-reflection layer includes a first coating layer disposed on top of the hard coating layer and a second coating layer disposed on top of the first coating layer.

According to the invention, each of the first coating layer and the second coating layer includes a material having a relatively larger elastic modulus than an elastic modulus of the flexible film.

In one or more embodiments, the first coating layer may include an inorganic material having a low refractive index of 1.5 or lower.

In one or more embodiments, the second coating layer may include an inorganic material having a higher refractive index than the refractive index of the first coating layer.

In one or more embodiments, the anti-reflection layer may include a stack structure.

In one or more embodiments, the stack structure may include the first coating layers and the second coating layers which may be alternately stacked on top of each other repeat.

In one or more embodiments, the flexible film may include an organic material having a low refractive index lower than a refractive index of the second coating layer.

In one or more embodiments, the anti-reflection layer may further include a second coating layer disposed under the flexible film and including an inorganic material having a high refractive index.

In one or more embodiments, the anti-reflection layer may further include upper and lower first coating layers vertically spaced apart from each other and including an inorganic material having a low refractive index.

In one or more embodiments, the second coating layer may be disposed between the upper and lower first coating layers.

In one or more embodiments, the anti-reflection layer may further include a second coating layer disposed under the flexible film and including an inorganic material having a high refractive index.

In one or more embodiments, the anti-reflection layer may further include upper and lower first coating layers vertically spaced apart from each other and including an inorganic material having a low refractive index.

In one or more embodiments, the second coating layer may be disposed between the upper and lower first coating layers.

In one or more embodiments, the flexible film may be disposed under the anti-fingerprint layer and/or may include an upper flexible film and a lower flexible film.

In one or more embodiments, the upper first coating layer may be disposed between the upper flexible film and the lower flexible film.

In one or more embodiments, the anti-reflection layer may include a stack in which the flexible films and first coating layers are alternately stacked on top of each other repeat.

In one or more embodiments, a lowest flexible film among the flexible films may contact the hard coating layer.

In one or more embodiments, each of the first coating layers may include an inorganic material with a higher elastic modulus than an elastic modulus of each of the flexible films.

In one or more embodiments, the anti-reflection layer may include a stack in which the flexible films and second coating layers are alternately stacked on top of each other.

In one or more embodiments, a lowest flexible film among the flexible films may contact the hard coating layer.

In one or more embodiments, each of the second coating layers may include an inorganic material with a higher elastic modulus than an elastic modulus of each of the flexible films.

In one or more embodiments, the flexible film may include an organic material having a refractive index lower than a refractive index of the second coating layer.

In one or more embodiments, the flexible film may include a flexible film stack in which first flexible films and second flexible films are alternately stacked on top of each other repeat.

In one or more embodiments, each of the first flexible films may have a first refractive index.

In one or more embodiments, each of the second flexible films may have a second refractive index lower than the first refractive index.

A display device according to another aspect of the present disclosure includes a cover window; and a display panel disposed under the cover window, wherein the cover window includes: a base substrate; a hard coating layer disposed on top of the base substrate; an anti-reflection layer disposed on top of the hard coating layer and including a flexible film; and an anti-fingerprint layer disposed on top of the anti-reflection layer.

The cover window according to an embodiment of the present disclosure includes the anti-reflection layer including at least one layer made of the organic material, so that cracks may be prevented from occurring therein even when the cover window is repeatedly folded or rolled.

Furthermore, the anti-reflective film including the organic material layer may be included in the cover window, such that the surface hardness and scratch resistance thereof are excellent, and thus, external shocks applied to the cover window may be effectively blocked. Accordingly, the product reliability of the display device may be improved.

Furthermore, according to an embodiment of the present disclosure, the layers made of the inorganic material with a relatively high elastic modulus and the layers made of the organic material with a relatively low elastic modulus are stacked on top of each other to form the anti-reflective film. Thus, the number of layers stacked vertically to form the anti-reflection film may be reduced. Accordingly, a thickness of the anti-reflection film may be reduced, making it possible to implement a lightweight cover window, thereby reducing the overall weight of the display device.

Effects of the present disclosure are not limited to the effects mentioned above, and other effects not mentioned will be clearly understood by those skilled in the art from the descriptions below.

### BRIEF DESCRIPTION OF DRAWINGS

FIG. 1 is a schematic cross-sectional view of a display device according to an embodiment of the present disclosure.
FIG. 2 to FIG. 4D are diagrams for illustrating a crack occurring in a cover window.
FIG. 5 is a cross-sectional view of a cover window of one embodiment of the present disclosure.
FIG. 6 a diagram for illustrating an organic material of an embodiment of the present disclosure.
FIG. 7 is a diagram showing a stress applied to a flexible film including an organic material in FIG. 6.
FIG. 8 is a SEM photo showing a surface of a cover window incorporating a flexible reinforcing film in accordance with the present disclosure.
FIG. 9 is a cross-sectional view of a cover window of another embodiment of the disclosure.
FIG. 10 a cross-sectional view of a cover window of still another embodiment of the disclosure.
FIG. 11 is a cross-sectional view of a cover window according to still yet another embodiment of the present disclosure.
FIG. 12 is a cross-sectional view of a cover window according to still yet another embodiment of the present disclosure.
FIG. 13 is a cross-sectional view of a cover window according to still yet another embodiment of the present disclosure.
FIG. 14 is a cross-sectional view of a cover window according to still yet another embodiment of the present disclosure.
FIG. 15 is a table for illustrating a durability of a cover window including a flexible film in accordance with the present disclosure.
FIG. 16A and FIG. 16B are pictures for comparing surface strengths of a cover window based on anti-reflection layer coating schemes with each other.

### DETAILED DESCRIPTIONS

Advantages and features of the present disclosure, and a method of achieving the advantages and features will become apparent with reference to embodiments described later in detail together with the accompanying drawings. However, the present disclosure is not limited to the embodiments as disclosed under, but may be implemented in various different forms. Thus, these embodiments are set forth only to make the present disclosure complete, and to completely inform the scope of the present disclosure to those of ordinary skill in the technical field to which the present disclosure belongs, and the present disclosure is only defined by the scope of the claims.

A shape, a size, a ratio, an angle, a number, etc. disclosed in the drawings for describing the embodiments of the present disclosure are exemplary, and embodiments of the present disclosure are not limited thereto. The same reference numerals refer to the same elements herein. Further, descriptions and details of well-known steps and elements are omitted for simplicity of the description. Furthermore, in the following detailed description of the present disclosure, numerous specific details are set forth in order to provide a thorough understanding of the present disclosure. However, it will be understood that the present disclosure may be practiced without these specific details. In other instances, well-known methods, procedures, components, and circuits have not been described in detail so as not to unnecessarily obscure aspects of the present disclosure. The terminology used herein is directed to the purpose of describing particular embodiments only and is not intended to be limiting of the present disclosure. As used herein, the singular constitutes "a" and "an" are intended to include the plural constitutes as well, unless the context clearly indicates otherwise. It will be further understood that the terms "comprise", "including", "include", and "including" when used in this specification, specify the presence of the stated features, integers, operations, elements, and/or components, but do not preclude the presence or addition of one or more other features, integers, operations, elements, components, and/or portions thereof.

In interpreting a numerical value, the value is interpreted as including an error range unless there is no separate explicit description thereof.

In addition, it will also be understood that when a first element or layer is referred to as being present "on" a second element or layer, the first element may be disposed directly on the second element or may be disposed indirectly on the second element with a third element or layer being disposed between the first and second elements or layers. It will be understood that when an element or layer is referred to as being "connected to", or "coupled to" another element or layer, it may be directly on, connected to, or coupled to the other element or layer, or one or more intervening elements or layers may be present. In addition, it will also be understood that when an element or layer is referred to as being "between" two elements or layers, it may be the only element or layer between the two elements or layers, or one or more intervening elements or layers may also be present.

In descriptions of temporal relationships, for example, temporal precedent relationships between two events such as "after", "subsequent to", "before", etc., another event may occur therebetween unless "directly after", "directly subsequent" or "directly before" is not indicated.

It will be understood that, although the terms "first", "second", "third", and so on may be used herein to describe various elements, components, regions, layers and/or sections, these elements, components, regions, layers and/or sections should not be limited by these terms. These terms are used to distinguish one element, component, region, layer or section from another element, component, region, layer or section. Thus, a first element, component, region, layer or section described under could be termed a second element, component, region, layer or section, without departing from the scope of the present disclosure.

The features of the various embodiments of the present disclosure may be partially or entirely combined with each other, and may be technically associated with each other or operate with each other. The embodiments may be implemented independently of each other and may be implemented together in an association relationship.

Hereinafter, a display device according to each of embodiments of the present disclosure is described with reference to the attached drawings.

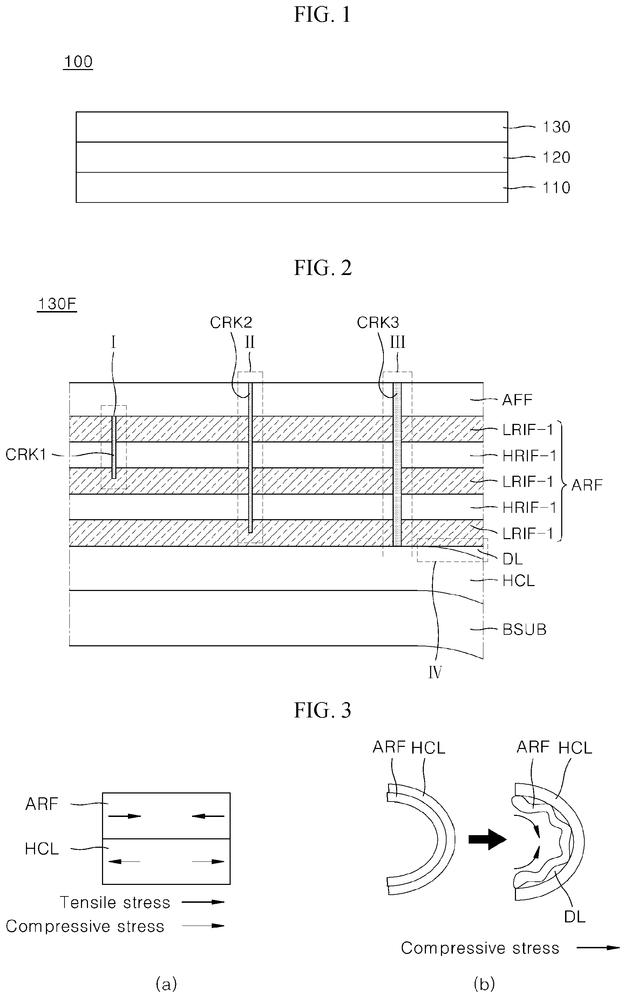

FIG. 1 is a schematic cross-sectional view of a display device according to an embodiment of the present disclosure.

Referring to FIG. 1, a display device 100 may include a substrate 110, a display panel 120, and a cover window 130.

The substrate 110 serves to support layers disposed thereon and may be made of a material with flexible properties such that the substate is bendable, rollable, or foldable.

Furthermore, the substrate 110 is disposed under the display panel 120 and serves to protect circuit elements and light-emitting elements disposed within the display panel 120 from an external environment. For example, the substrate 110 may prevent moisture from penetrating into the display panel 120 and absorb external shocks. The substrate 110 may include, for example, a plastic material such as polyimide, polycarbonate, or polyethylene terephthalate.

The display panel 120 is an element that may display an image and may be flexible. The display panel 120 may include a plurality of pixels, and each pixel may display an image to an outside out of the display panel 120 using a light-emitting element. The light-emitting element may include an organic light-emitting element (for example, OLED; organic light- emitting diode) that may emit light on its own for displaying an image. However, the light-emitting element is not limited to the organic light-emitting element. The display panel 120 may include a plurality of circuit elements including a thin-film transistor electrically connected to the organic light-emitting element to drive the organic light-emitting element.

The cover window 130 may be disposed on the display panel 120. The cover window 130 may serve to protect a number of circuit elements, such as an organic light-emitting element or a thin-film transistor disposed within the display panel 120 from external impact. Accordingly, the cover window 130 should have surface hardness and scratch resistance to absorb and block shock applied from the outside.

Additionally, the cover window 130 serves to deliver the image screen displayed from the display panel 120 to the user. Accordingly, the cover window 130 may include a transparent material.

The flexible display device may be able to significantly reduce the size thereof because the device is foldable or rollable and may display an image in the folded state. During a process of folding or rolling the flexible display device, the cover window 130 may also be subject to stress due to the folding or rolling operation. In this case, defects such as cracks may occur in the cover window 130.

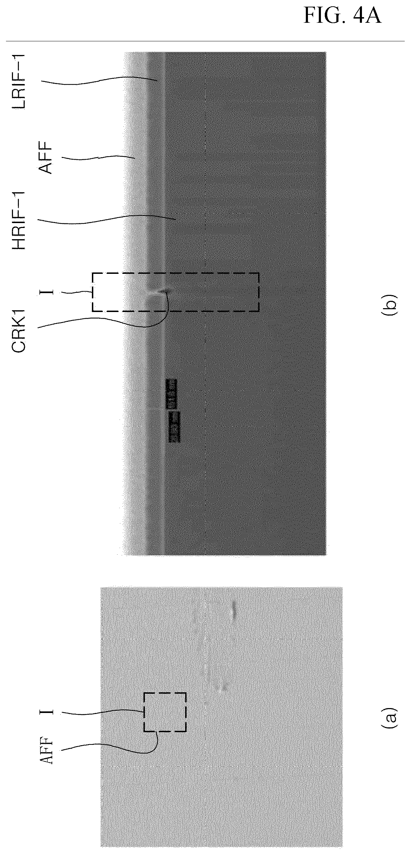

FIG. 2 to FIG. 4D are diagrams for illustrating a defect occurring in the cover window. FIG. 2 is a cross-sectional view for illustrating a defective cover window. FIG. 3 is a diagram for illustrating a cause of the defect that has occurred in the cover window. FIG. 4A to FIG. 4D are diagrams for illustrating a defect occurring in the cover window.

First, referring to FIG. 2, the cover window 130F may be made of a multi-layer structure in which a base substrate BSUB, a hard coating layer HCL, an anti-reflection layer ARF, and an anti-fingerprint layer AFF are stacked. Additionally, although not shown in the drawing, the cover window 130F may further include an anti-pollution layer or an anti-glare layer.

A top surface of the anti-fingerprint layer AFF as the highest layer of the cover window 130F may be exposed to the external environment. The anti-fingerprint layer AFF may prevent a quality of the image screen from deteriorating due to a fingerprint remaining on the surface of the cover window 130F. Additionally, the anti-fingerprint layer AFF may be located as the top layer of the cover window 130F and may be exposed to the external environment and thus may serve to protect the surface of the cover window 130F from scratches.

The other surface of the base substrate BSUB facing the anti-fingerprint layer AFF may be bonded to the display panel 120 (see FIG. 1).

The base substrate BSUB protects the cover window 130F from external shock and serves to support the layers disposed on top of the base substrate BSUB. For this purpose, the base substrate BSUB may include, for example, glass or a plastic film made of polyimide.

The hard coating layer HCL may be disposed on the base substrate BSUB. The hard coating layer HCL may be disposed on one surface of the base substrate BSUB. The hard coating layer HCL may include a material with excellent surface hardness. For example, the hard coating layer HCL may include at least one resin such as epoxy resin, acrylic resin, or silicone resin.

The anti-reflection layer ARF may be disposed on the hard coating layer HCL. When a lot of external light is reflected from the cover window 130F, it may be difficult for the user to identify the screen emitted from the display panel. As the external light is mainly reflected on the surface of the cover window 130F, it is important to reduce the reflectance of the cover window 130F. Accordingly, the anti-reflection layer ARF of the cover window 130F may prevent the external light from being reflected therefrom and thus deteriorating screen quality.

The anti-reflection layer ARF may include a multilayer structure in which first coating layers LRIF-1 and second coating layers HRIF-1 are alternately stacked on top of each other. The anti-reflection layer ARF having the multi-layer structure in which the first coating layers LRIF-1 and the second coating layers HRIF-1 are alternately stacked on top of each other may be used to reduce reflectance of the external light via destructive interference occurring during an interfacial reflection process.

In order that the anti-reflection layer ARF in FIG. 2 generates the destructive interference effect, the first coating layer LRIF-1 may include an inorganic material with a relatively lower refractive index and the second coating layer HRIF-1 thereof may include an inorganic material having a relatively higher refractive index than that of the first coating layer LRIF-1.

The first coating layer LRIF-1 may include an inorganic material having a low refractive index of 1.5 or lower. For example, the first coating layer LRIF-1 may include an inorganic material including silicon oxide (SiO₂). The second coating layer HRIF-1 may include an inorganic material having a high refractive index greater than 2.0. For example, the second coating layer HRIF-1 may include an inorganic material including titanium oxide (Ti₃O₅) or niobium pentoxide (Nb₂O₅).

As the number of thin-films of the anti-reflection layer ARF overlapping each other increases, the anti-reflection layer ARF may reduce the reflectance of the external light therefrom. Thus, the anti-reflection layer ARF may have the stack structure in which the first coating layers LRIF-1 and the second coating layers HRIF-1 with different refractive indices are alternately stacked on top of each other. Specifically, the anti-reflection layer ARF may include three first coating layers LRIF-1 and two second coating layers HRIF-1.

The anti-fingerprint layer AFF may be disposed on the anti-reflection layer ARF so as to prevent clarity of the screen from being deteriorated by the user's fingerprint.

When the anti-reflection layer ARF is made of a single inorganic material, defects such as cracks CRK1, CRK2, and CRK3 or delamination DL may occur when an operation of folding or rolling the display panel is repeated. Securing folding reliability in the flexible display device is related to product reliability. Thus, it is important to prevent defects such as cracks or delamination from occurring in the cover window.

A difference between the stress directions of the hard coating layer HCL and the anti-reflection layer ARF may be one of the causes of cracks in the cover window. For example, referring to (a) in FIG. 3, when the display panel is repeatedly folded or rolled, a tensile stress in a first direction occurs in the hard coating layer HCL of the cover window while a compressive stress in a second direction different from the first direction occurs in the anti-reflection layer ARF thereof. Thus, the stress in the anti-reflection layer ARF may increase, which may cause the cracks CRK1, CRK2, and CRK3 in the cover window 130F.

For example, referring to FIG. 2 and FIG. 4A, cracks are not visible from the surface of the anti-fingerprint layer AFF of the cover window 130F (see (a) in FIG. 4A). However, as shown in a scanning microscope (SEM) image of (b) in FIG. 4A which shows a cross-section of a 'I' area, a first crack CRK1 is present in the first coating layer LRIF-1 and the second coating layer HRIF-1 under the anti-fingerprint layer AFF.

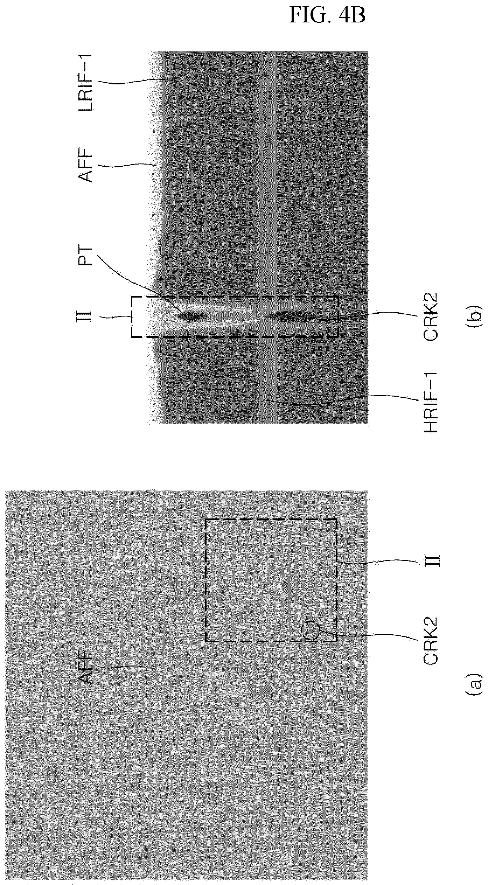

Further, referring to FIG. 2 and FIG. 4B, a fine second crack CRK2 is recognized from the surface of the anti-fingerprint layer AFF of the cover window 130F (see (b) in FIG. 4A). Further, as shown in a scanning microscope (SEM) image as shown in (b) of FIG. 4B which shows a cross-section of a 'II' area where the second crack CRK2 occurs, the second crack CRK2 as well as a foreign matter PT are present in the first coating layer LRIF-1 and the second coating layer HRIF-1 under the anti-fingerprint layer AFF.

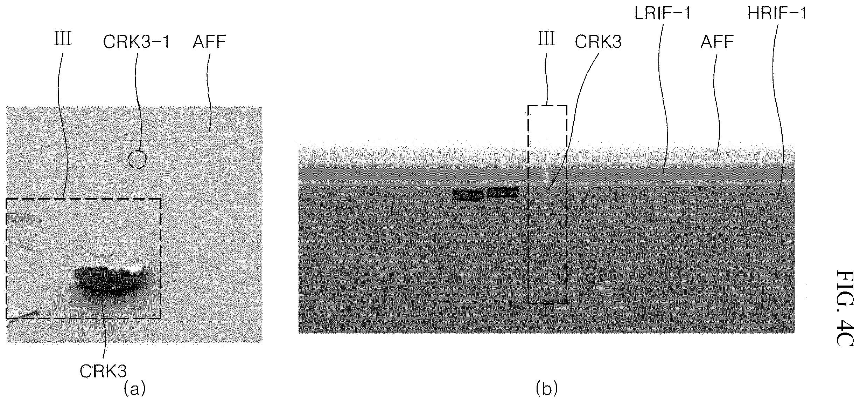

Further, referring to FIG. 2 and FIG. 4C, the third crack CRK3 is clearly visible from the surface of the anti-fingerprint layer AFF of the cover window 130F (see (a) in FIG. 4C). Further, as shown in a scanning microscope (SEM) image as shown in (b) of FIG. 4C which shows a cross-section of a 'III' area where the third crack CRK2 occurs, the third crack CRK2 is present in the first coating layer LRIF-1 and the second coating layer HRIF-1 under the anti-fingerprint layer AFF. In addition, additional fine cracks CRK3-1 may occur in a position adjacent to the clearly visible third crack CRK3.

Furthermore, delamination DL may occur when there is insufficient adhesion between the hard coating layer HCL and the anti-reflection layer ARF bonded to each other. For example, referring to (b) in FIG. 3, when the display panel is repeatedly folded or rolled while the adhesion between the hard coating layer HCL and the adhered anti-reflection layer ARF is insufficient, the stress in the anti-reflection layer ARF may increases due to the compressive stress occurring in the anti-reflection layer ARF of the cover window, such that the delamination DL may occur in the cover window 130F.

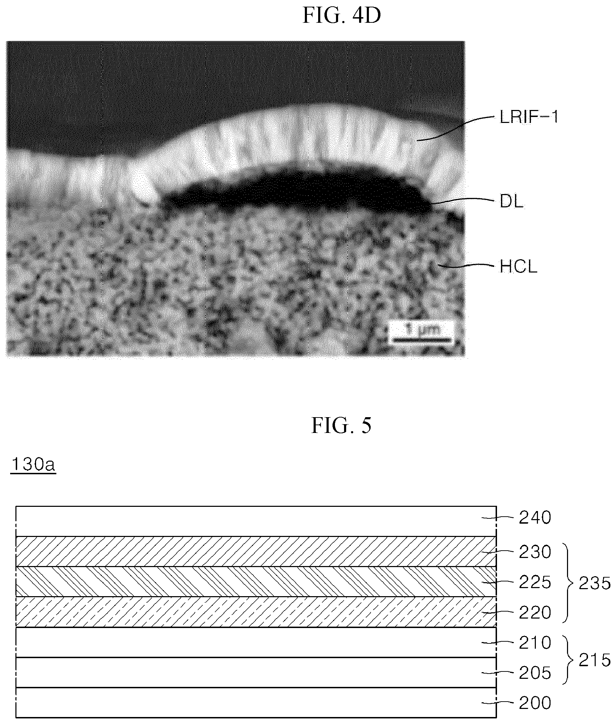

For example, referring to a 'IV' area in FIG. 2 and FIG. 4D, when the display panel is repeatedly folded or rolled while the adhesion between the hard coating layer HCL and the first coating layer LRIF-1 made of the inorganic material is insufficient, delamination between the hard coating layer HCL and the first coating layer LRIF-1 occurs due to bulking in a portion DL.

The defects such as the cracks CRK1, CRK2, and CRK3 or the delamination DL due to the bulking may increase as the stress applied to the cover window 130F increases as the folding or rolling operation of the flexible display device is repeated. Thus, a product quality of the display device may deteriorate, and screen defects may be caused.

Accordingly, in embodiments of the present disclosure, the reliability of the product may be improved by preventing the cracks and delamination defects from occurring in the cover window. Furthermore, the product reliability may be improved by improving the surface strength, scratch resistance, and abrasion-resistance of the anti-reflection layer provided in the cover window. Furthermore, the optical property of the cover window may be improved by reducing the reflectance of the external light therefrom while maintaining product reliability.

This will be described with reference to the drawings below.

FIG. 5 is a cross-sectional view of a cover window according to one embodiment of the present disclosure.

Referring to FIG. 5, a cover window 130a according to one embodiment of the present disclosure may include a multi-layer structure in which a base substrate 200, a hard coating layer 215, an anti-reflection layer 235 having a flexible film 230 as a top layer thereof, and an anti-fingerprint layer 240 are stacked. Additionally, although not shown in the drawing, the cover window 130a may further include an anti-pollution layer or an anti-glare layer.

A top surface of the anti-fingerprint layer 240 of the cover window 130a may be exposed to the external environment. The base substrate 200 disposed opposite the anti-fingerprint layer 240 may be bonded to one surface of the display panel 120 (see FIG. 1).

The base substrate 200 serves to protect the cover window 130a from external shock while supporting the hard coating layer 215 disposed on top thereof. To this end, the base substrate 200 may include a glass or a plastic film made of polyethylene terephthalate (PET), polyimide, or polymethylmethacrylate (PMMA).

The hard coating layer 215 may be disposed on the base substrate 200. The hard coating layer 215 may be disposed on the other surface of the base substrate 200 opposite to the one surface thereof bonded to the display panel 120 (see FIG. 1).

The hard coating layer 215 may include a first hard coating layer 205 and a second hard coating layer 210. The first hard coating layer 205 and the second hard coating layer 210 may respectively include materials having different hardnesses to improve the surface hardness of the cover window 130a. Each of the first hard coating layer 205 and the second hard coating layer 210 may include a material having excellent surface hardness. For example, each of the first hard coating layer 205 and the second hard coating layer 210 may include one or more types of resin such as epoxy resin, acrylic resin, or silicone resin.

The anti-reflection layer 235 may be disposed on the hard coating layer 215. The anti-reflection layer 235 may include a multilayer structure in which first coating layers 220 and second coating layers 225 are alternately stacked on top of each other. The flexible film 230 is disposed as the top layer of the anti-reflection layer 235. The first coating layer 220 of the anti-reflection layer 235 may include an inorganic material having a low refractive index, and the second coating layer 225 may include an inorganic material having a high refractive index.

The first coating layer 220 may include an inorganic material having a low refractive index of 1.5 or lower. For example, the first coating layer 220 may include silicon oxide (SiO₂). However, embodiments of the present disclosure are not limited thereto. Any inorganic material with a refractive index of 1.5 or lower may be applied as the first coating layer 220.

The second coating layer 225 may include an inorganic material having a relatively higher refractive index than that of the first coating layer 220. The second coating layer 225 may include an inorganic material having a high refractive index greater than 2.0. For example, the second coating layer 225 may include titanium oxide (Ti₃O₅) or niobium pentoxide (Nb₂O₅). However, embodiments of the present disclosure are not limited thereto. Any inorganic material with a refractive index greater than 2.0 may be applied as the second coating layer 225.

The flexible film 230 is disposed on the second coating layer 225. The flexible film 230 includes a material having a relatively lower elastic modulus than that of each of the first coating layer 220 and the second coating layer 225, such that the flexible film 230 has flexibility and is easily stretched. For example, the flexible film 230 may include an organic material. The flexible film 230 may be made of an organic material having a low refractive index, for example, a refractive index of 1.3 to 1.47 that is relatively lower than that of the second coating layer 225, and having a light transmittance of 93% or greater.

In one example, the anti-reflection layer 235 may be formed by repeatedly stacking a multilayer structure in which the first coating layers 220, the second coating layers 225, and the flexible films 230 are alternately arranged vertically on top of each other. For example, a structure in which the first coating layer 220, the second coating layer 225, and the flexible film 230 are vertically arranged may be defined as a single stack. The anti-reflection layer 235 may include a vertical arrangement of at least two stacks. In this case, the flexible film 230 is disposed as the top layer of the anti-reflection layer 235.

In another example, the flexible film 230 may be made of an organic material having a relatively higher refractive index than that of the first coating layer 220. For example, the flexible film 230 may include an organic material that has a refractive index in a range of 1.6 to 2.0 and a light transmittance of 93% or greater. When the flexible film 230 is made of the organic material having a relatively higher refractive index than that of the first coating layer 220, the anti-reflection layer 235 may include a stack in which the second coating layer 225, the first coating layer 220 and the flexible film 230 are stacked in this order.

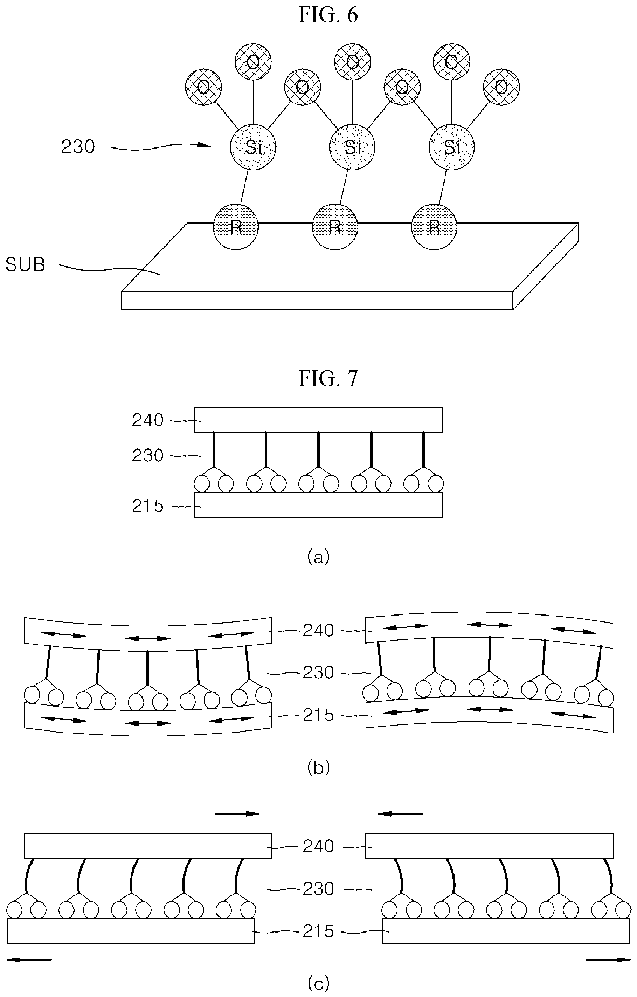

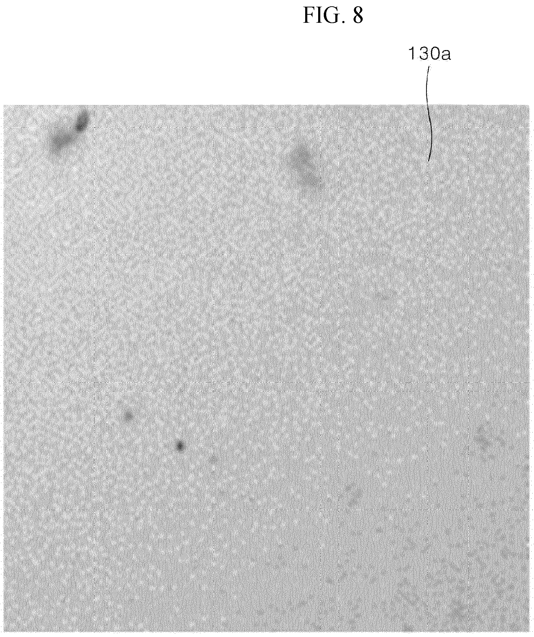

FIG. 6 is a diagram for illustrating an organic material according to an embodiment of the present disclosure. FIG. 7 is a diagram showing a stress applied to the flexible film including the organic material in FIG. 6. FIG. 8 is an SEM photo showing a surface of a cover window incorporating a flexible reinforcing film in accordance with the present disclosure.

Referring to FIG. 6, the organic material included in the flexible film 230 may include a polymer compound including a silicone-based polymer and a functional organic-inorganic silane compound. The polymer compound including the silicone-based polymer and the functional organic-inorganic silane compound may have a functional group that has good bonding power to a base material SUB and a functional group that can bind to a layer on top thereof. The functional organic-inorganic silane compound may be an organic-inorganic silane compound having at least one functional group, for example, an amino group, a vinyl group, an epoxy group, an alkoxy group, or a halogen group that reacts with the silicone-based polymer. However, embodiments of the present disclosure are not limited thereto.

For example, the organic material may include a mixture of urethane and at least one of silane, low-concentration silane, high-concentration silane, or a silane compound. In this regard, the low-concentration silane may be a compound containing silane at a relatively low concentration, and the high-concentration silane may be a compound containing silane at a relatively high concentration. For example, the low-concentration silane may contain silane at a content of 10% to 20% based on a total weight of the organic material. The high-concentration silane may contain silane at a content of 15% to 25% based on a total weight of the organic material.

The flexible film 230 made of the organic material including the polymer compound including the functional organic-inorganic silane compound and the silicone-based polymer may have a low refractive index in a range of 1.3 to 1.47 by adjusting a content ratio of the silicone-based polymer and the functional organic-inorganic silane compound.

Furthermore, the flexible film 230 made of the organic material including the polymer compound including the functional organic-inorganic silane compound and the silicone-based polymer may have a high refractive index in a range of 1.6 to 2.0 by adjusting a content ratio of the silicone-based polymer and the functional organic-inorganic silane compound.

The flexible film 230 including the organic material has the functional group that has good bonding power to the base material SUB and the functional group that can bind to the layer on top thereof. Thus, durability may be strengthened by improving adhesion thereof to the base material SUB. For example, the base material SUB may be the second coating layer 225 bonded to one surface of the flexible film 230 in one embodiment of the present disclosure. Furthermore, the functional group of the organic material capable of bonding to the layer on top thereof may contact and bind to the anti-fingerprint layer 240.

The flexible film 230 disposed as the top layer of the anti-reflection layer 230 may be made of an organic material and has a relatively lower modulus than that of the first coating layer 220 and the second coating layer 225 including the inorganic material disposed thereunder. Thus, the flexibility of the flexible film 230 is higher than that of the first coating layer 220 and the second coating layer 225. Accordingly, even when the folding operation or the bending operation is repeatedly performed, the stress in the flexible film 230 may be prevented from increasing, thereby preventing cracks from occurring.

For example, referring to FIG. 7, the cover window may be configured to include the hard coating layer 215, the flexible film 230, and the anti-fingerprint layer 240 (see (a) in FIG. 7). One surface of the flexible film 230 including the organic material may contact the hard coating layer 215, and the other surface thereof may contact the anti-fingerprint layer 240. The first coating layer 220 or the second coating layer 225 may be further disposed between the flexible film 230 and the hard coating layer 215.

The bending or folding of the cover window including the flexible film 230 (see (b) in FIG. 7) or stretching of the cover window (see (c) in FIG. 7) is performed. In this regard, as the flexible film 230 is made of the organic material with a relatively low modulus, the stress including the compressive stress or the tensile stress may be prevented from being applied to the flexible film 230, or the stress including the compressive stress or the tensile stress applied to the flexible film 230 may be prevented from increasing.

Accordingly, as shown in FIG. 8, it may be identified that the cover window 130a including the flexible film in the anti-reflection layer according to the present disclosure has a clean surface without cracks.

In addition, the flexible film 230 including the organic material has a refractive index of 1.3 to 1.47, and thus has a refractive index similar to that of silicon oxide as a low refractive index layer. Accordingly, the flexible film 230 as the top layer of the anti-reflection layer 235 may be disposed on top of the second coating layer 225 of the anti-reflection layer 235 made of the inorganic material having a high refractive index, and may reduce the reflectance of the external light from the anti-reflection layer 235 under the destructive interference effect occurring during the interfacial reflection process.

When the reflectance thereof has a value greater than 1.2%, the external light may be reflected therefrom, making it difficult for the user to identify the screen emitted from the display panel. Accordingly, it is desirable for the reflectance thereof to have a value smaller than 1.2%.

The reflectance of the cover window 130a including the anti-reflection layer 235 including the flexible film 230 according to an embodiment of the present disclosure may be lower than 1.2%, for example, lower than 1.0%.

The anti-fingerprint layer 240 may be disposed on the flexible film 230. The anti-fingerprint layer AFF may act as a top layer of the cover window 130a and may serve to protect the surface of the cover window from scratches as the anti-fingerprint layer AFF is exposed to the external environment.

The anti-reflection layer 235 according to one embodiment of the present disclosure may be composed of the stack of the three layers: the first coating layer 220, the second coating layer 225, and the flexible film 230. Thus, an overall thickness of the cover window 130a may be reduced, thereby reducing an overall thickness of the display device.

Furthermore, the cover window 130a includes the flexible film 230 made of the organic material such that the abrasion-resistance and the scratch resistance of the cover window may be improved.

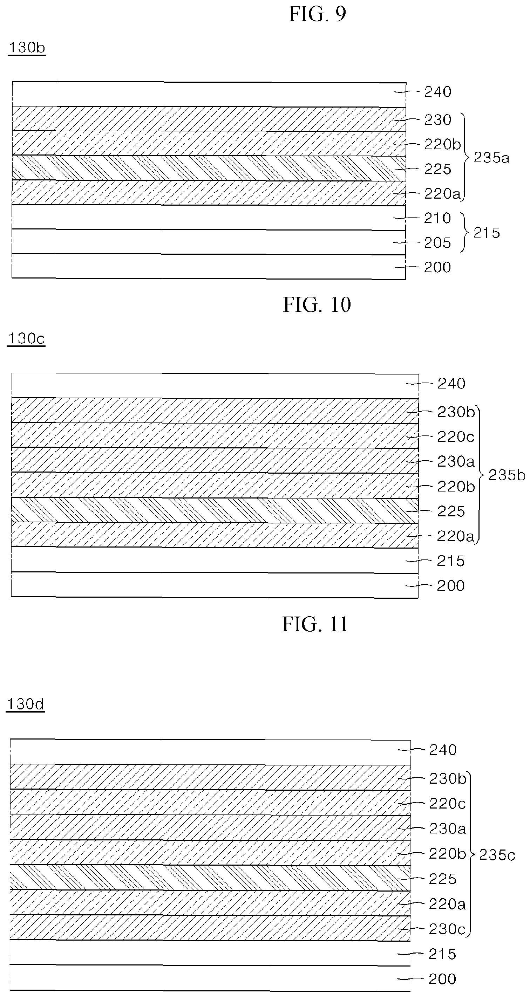

FIG. 9 is a cross-sectional view of a cover window according to another embodiment of the present disclosure. Other components except for the anti-reflection layer in FIG. 9 are the same as those in FIG. 5. Accordingly, the components indicated with the same reference numerals as those in FIG. 5 may be briefly described or descriptions thereof may be omitted.

A cover window according to another embodiment of the present disclosure may reduce reflection of external light by strengthening the destructive interference effect of the anti-reflection layer.

Referring to FIG. 9, a cover window 130b may have the hard coating layer 215 disposed on the base substrate 200.

An anti-reflection layer 235a may be disposed on the hard coating layer 215. The anti-reflection layer 235a of the cover window 130b according to another embodiment of the present disclosure may have a stack structure of first coating layers 220a and 220b, the second coating layer 225, and the flexible film 230. The anti-reflection layer 235a may have the structure in which the second coating layer 225 including an inorganic material having a high refractive index is disposed between the first coating layers 220a and 220b including an inorganic material having a low refractive index and vertically spaced apart from each other. Thus, the destructive interference may occur between the second coating layer 225 and the first coating layers 220a and between the second coating layer 225 and the first coating layers 220b, thereby further reducing the reflection of the external light from the cover window 130b.

Each of the first coating layers 220a and 220b including the inorganic material having a low refractive index may include an inorganic material having a low refractive index of 1.5 or lower. For example, each of the first coating layers 220a and 220b may include silicon oxide SiO₂. The second coating layer 225 including an inorganic material with a high refractive index may include an inorganic material with a high refractive index greater than 2.0. For example, the second coating layer 225 may include titanium oxide (Ti₃O₅) or niobium pentoxide (Nb₂O₅).

Furthermore, the flexible film 230 including an organic material may be disposed as a top layer of the anti-reflection layer 235a having the stack structure. Thus, when the cover window 130b is folded, bent, or rolled repeatedly, cracks may be prevented from occurring in the anti-reflection layer 235. The anti-fingerprint layer 240 may be disposed on top of the flexible film 230.

According to another embodiment of the present disclosure, the destructive interference may occur in a double manner, that is, may occur between the second coating layer 225 and the first coating layers 220a and between the second coating layer 225 and the first coating layers 220b, thereby further reducing the reflection of the external light from the cover window 130b.

FIG. 10 is a cross-sectional view of a cover window according to still another embodiment of the present disclosure. Other components except for the anti-reflection layer in FIG. 10 are the same as those in FIG. 5. Accordingly, the components indicated with the same reference numerals as those in FIG. 5 may be briefly described or descriptions thereof may be omitted.

A cover window 130c according to still another embodiment of the present disclosure may include flexible films 230a and 230b including the organic material to further improve the flexibility of the cover window 130c.

Referring to FIG. 10, the cover window 130c may have the hard coating layer 215 disposed on the base substrate 200. The hard coating layer 215 may include a single layer structure. Alternatively, the hard coating layer 215 may include a stack structure of the first hard coating layer 205 and the second hard coating layer 210, as shown in FIG. 5.

An anti-reflection layer 235b may be disposed on top of the hard coating layer 215. The anti-reflection layer 235b of the cover window 130c according to another embodiment of the present disclosure may include a stack structure in which the first coating layer 220a, the second coating layer 225, the first coating layer 220b, the first flexible film 230a, a first coating layer 220c, and the second flexible film 230b are stacked. The anti-reflection layer 235b may have the structure in which the second coating layer 225 including an inorganic material having a high refractive index is disposed between the first coating layers 220a and 220b including an inorganic material having a low refractive index and vertically spaced apart from each other. Thus, the destructive interference may occur between the second coating layer 225 and the first coating layers 220a and between the second coating layer 225 and the first coating layers 220b, thereby further reducing the reflection of the external light from the cover window 130c.

Furthermore, the first flexible film 230a and the second flexible film 230b may be vertically spaced apart from each other and may be disposed under the anti-fingerprint layer 240 disposed as the top layer of the cover window 130c. The first coating layer 220c may be disposed between the first flexible film 230a and the second flexible film 230b. One surface of the second flexible film 230b may be in contact with the anti-fingerprint layer 240 while the other surface thereof may be in contact with the first coating layer 220c.

One surface of the first coating layer 220c that is not in contact with the second flexible film 230b may be disposed in contact with one surface of the first flexible film 230a. The other surface of the first flexible film 230a may be in contact with the first coating layer 220b.

Each of the first coating layers 220a, 220b, and 220c including an inorganic material having a low refractive index may include an inorganic material having a low refractive index of 1.5 or lower. For example, each of the first coating layers 220a, 220b, and 220c may include silicon oxide (SiO₂). The second coating layer 225 including an inorganic material with a high refractive index may include an inorganic material with a high refractive index greater than 2.0. For example, the second coating layer 225 may include titanium oxide (Ti₃O₅) or niobium pentoxide (Nb₂O₅).

The cover window 130c according to still another embodiment of the present disclosure may include the two flexible films 230a and 230b including the organic material and having the lower elastic modulus than that of each of the first coating layers 220a, 220b, and 220c or that of the second coating layer 225. Accordingly, the flexibility of the cover window 130c may be further increased, compared to a case in which a single flexible film is present. Thus, cracks may be prevented from occurring in the anti-reflection layer 235b even when the cover window 130c is repeatedly folded or rolled.

The organic material constituting the flexible film according to an embodiment of the present disclosure may contain the functional group with good bonding power to the base material and the functional group capable of binding to the layer on top thereof. Accordingly, the adhesion of the anti-reflection layer with the hard coating layer which serves as the base material in contact with the flexible film may be enhanced, thereby preventing the defects such as the delamination. This will be described with reference to the drawings.

FIG. 11 is a cross-sectional view of a cover window according to still yet another embodiment of the present disclosure. Other components except for the anti-reflection layer in FIG. 11 are the same as those in FIG. 10. Accordingly, the components indicated with the same reference numerals as those in FIG. 10 may be briefly described or descriptions thereof may be omitted.

In a cover window 130d according to still yet another embodiment of the present disclosure, one surface of a flexible film 230c including an organic material may be in contact with one surface of the hard coating layer to further increase the adhesive force between thin-films of the cover window.

Referring to FIG. 11, the cover window 130d may have the hard coating layer 215 disposed on the base substrate 200.

An anti-reflection layer 235c may be disposed on the hard coating layer 215. The anti-reflection layer 235c of the cover window 130d according to still yet another embodiment of the present disclosure may have a stack structure in which the third flexible film 230c, the first coating layer 220a, the second coating layer 225, the first coating layer 220b, the first flexible film 230a, the first coating layer 220c, and the second flexible film 230b are stacked.

One surface of the hard coating layer 215 may be in contact with one surface of the third flexible film 230c. The third flexible film 230c may include the organic material. The organic material may contain the silicone-based polymer and the functional organic-inorganic silane compound.

The organic material of the third flexible film 230c may include the polymer compound containing the silicone-based polymer and the functional organic-inorganic silane compound as described in FIG. 6. The polymer compound including the silicone-based polymer and the functional organic-inorganic silane compound may have the functional group that has good bonding power to the base material and the functional group that can bind to a layer on top thereof. The functional organic-inorganic silane compound may be an organic-inorganic silane compound having at least one functional group, for example, an amino group, a vinyl group, an epoxy group, an alkoxy group, or a halogen group that reacts with the silicone-based polymer. However, embodiments of the present disclosure are not limited thereto.

The third flexible film 230c including the organic material has the functional group that has good bonding power to the base material and the functional group that can bind to the layer on top thereof, thereby improving the adhesion of the anti-reflection layer to the base material, for example, the hard coating layer 215. This may enhance durability of the display device. Accordingly, the delamination DL between the hard coating layer HCL and the first coating layer LRIF-1 of the anti-reflection layer may be prevented. However, conventionally, when the hard coating layer 215 is adhered to a coating layer including an inorganic material, the delamination DL therebetween may occur due to a bulking effect caused by insufficient adhesion therebetween, as shown in FIG. 4D.

Furthermore, according to still yet another embodiment of the present disclosure, the destructive interference may occur in a double manner, that is, may occur between the second coating layer 225 and the first coating layers 220a and between the second coating layer 225 and the first coating layers 220b, thereby further reducing the reflection of the external light from the cover window 130d.

Furthermore, the flexible film 230b including the organic material may constitute the top layer of the anti-reflection layer 235c having the stack structure. Thus, even when the cover window 130d is repeatedly folded or rolled, cracks may be prevented from occurring in the anti-reflection layer 235c.

Furthermore, the durability of the cover window 130d may be improved by including the flexible films 230a, 230b, and 230c including the organic material into the anti-reflection layer 235c.

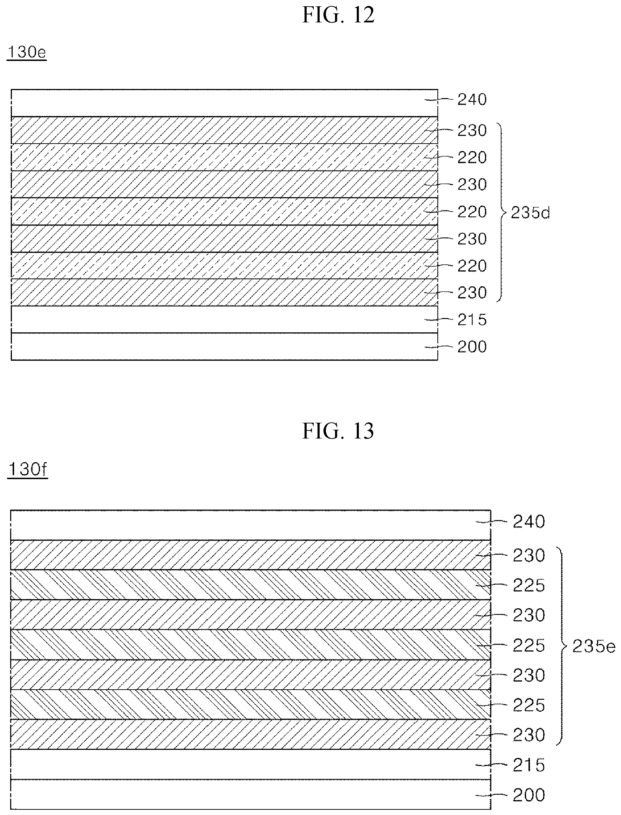

FIG. 12 is a cross-sectional view of a cover window according to still yet another embodiment of the present disclosure. Other components except for the anti-reflection layer in FIG. 12 are the same as those in FIG. 5. Accordingly, the components indicated with the same reference numerals as those in FIG. 5 may be briefly described or descriptions thereof may be omitted.

Referring to FIG. 12, a cover window 130e according to still yet another embodiment of the present disclosure may have the hard coating layer 215 disposed on the base substrate 200.

An anti-reflection layer 235d may be disposed on the hard coating layer 215. The anti-reflection layer 235d of the cover window 130e according to still yet another embodiment of the present disclosure may include the flexible films 230 and the first coating layers 220. The flexible films 230 and the first coating layers 220 may be alternately stacked on top of each other. A stack in which the flexible film 230 and the first coating layer 220 are stacked on top of each other may be defined as a unit stack. In this regard, unit stacks may be repeatedly vertically arranged to form the anti-reflection layer 235d. For example, the number of the unit stacks may be at least two.

The first coating layer 220 may include an inorganic material having a low refractive index of 1.5 or lower. For example, the first coating layer 220 may include silicon oxide (SiO₂). However, embodiments of the present disclosure are not limited thereto. Any inorganic material with a refractive index of 1.5 or lower may be applied as the material of the first coating layer 220.

The flexible film 230 may include an organic material that has a relatively lower elastic modulus than that of the first coating layer 220, such that the flexibility of the flexible film 230 may be secured and the flexible film 230 may be easily stretched.

The flexible film 230 is disposed as the top layer of the anti-reflection layer 235d. When the flexible film 230 is disposed as the top layer of the anti-reflection layer 235d, the stress applied to the cover window 130e may be prevented from increasing even when folding or bending operations of the cover window 130e are repeated, thereby preventing cracks from occurring in the cover window 130e.

Furthermore, the flexible film 230 is disposed as the bottom layer of the anti-reflection layer 235d so that the flexible film 230 contacts one surface of the hard coating layer. Accordingly, the bonding strength between the thin-films of the cover window 130e may be further improved to prevent delamination defects from occurring.

In one example, the flexible film 230 may include an organic material having a high refractive index in a range of 1.6 to 2.0. For example, the organic material included in the flexible film 230 may include the polymer compound containing the silicone-based polymer and the functional organic-inorganic silane compound. This flexible film 230 may have a high refractive index in a range of 1.6 to 2.0 by adjusting a content ratio of the silicone-based polymer and the functional organic-inorganic silane compound contained in the polymer compound.

FIG. 13 is a cross-sectional view of a cover window according to still yet another embodiment of the present disclosure. Other components except for the anti-reflection layer in FIG. 13 are the same as those in FIG. 5. Accordingly, the components indicated with the same reference numerals as those in FIG. 5 may be briefly described or descriptions thereof may be omitted.

Referring to FIG. 13, a cover window 130f according to still yet another embodiment of the present disclosure may have the hard coating layer 215 disposed on the base substrate 200.

An anti-reflection layer 235e may be disposed on the hard coating layer 215. The anti-reflection layer 235e of the cover window 130f according to still yet another embodiment of the present disclosure may include the flexible films 230 and the second coating layers 225. The flexible film 230 and the second coating layers 225 may be alternately stacked on top of each other. A stack structure in which the flexible film 230 and the second coating layer 225 are stacked on top of each other may be defined as a unit stack. In this regard, the unit stacks may be repeatedly vertically arranged to form the anti-reflection layer 235e. For example, the number of the unit stacks may be at least two.

The second coating layer 225 may include an inorganic material having a high refractive index greater than 2.0. For example, the second coating layer 225 may include titanium oxide (Ti₃O₅) or niobium pentoxide (Nb₂O₅). However, embodiments of the present disclosure are not limited thereto. An inorganic material with a refractive index greater than 2.0 may be applied as the material of the second coating layer 225.

The flexible film 230 may include an organic material that has a relatively lower elastic modulus than that of the second coating layer 225, such that the flexibility of the flexible film 230 is secured and the flexible film 230 is easily stretched. Furthermore, the flexible film 230 may be made of an organic material having a low refractive index that is lower than that of the second coating layer 220. For example, the flexible film 230 may be made of an organic material having a refractive index in a range of 1.3 to 1.47, and a light transmittance of 93% or greater.

The anti-reflection layer 235e may include a multilayer structure in which the flexible films 230 having a relatively low refractive index and the second coating layers 225 having a relatively high refractive index are alternately stacked on top of each other. Accordingly, the anti-reflection layer 235e may reduce the reflectance of the external light therefrom under a destructive interference effect that occurs during the interfacial reflection process.

The flexible film 230 is disposed as the top layer of the anti-reflection layer 235e. When the flexible film 230 is disposed as the top layer of the anti-reflection layer 235e, the stress applied to the cover window 130f may be prevented from increasing even when folding or bending operations of the cover window 130f are repeated, thereby preventing cracks from occurring in the cover window 130f.

Furthermore, the flexible film 230 is disposed as the bottom layer of the anti-reflection layer 235e so that the flexible film 230 contacts one surface of the hard coating layer. Accordingly, the bonding strength between the thin-films of the cover window 130f may be further improved to prevent delamination defects from occurring.

The anti-reflection layer may be free of the inorganic material but may be composed only of the flexible film including the organic material. This will be described with reference to the drawings.

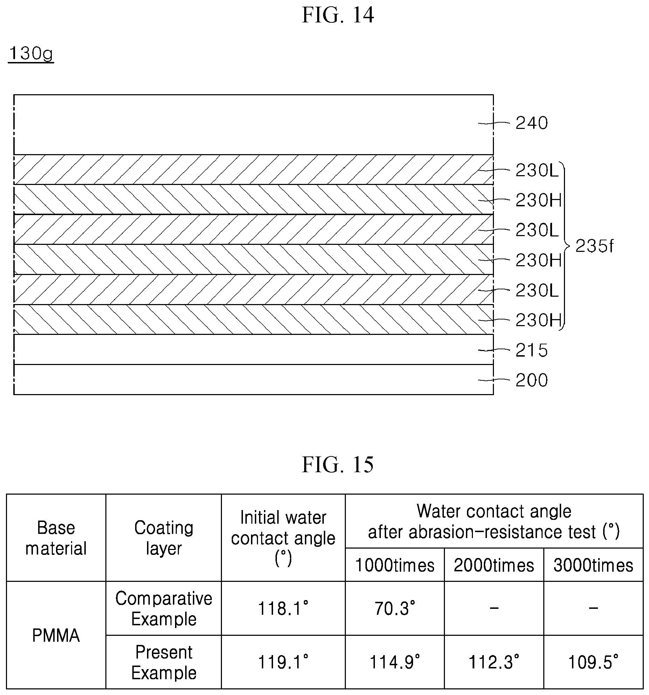

FIG. 14 is a cross-sectional view of a cover window according to still yet another embodiment of the present disclosure. Other components except for the anti-reflection layer in FIG. 14 are the same as those in FIG. 13. Accordingly, the components indicated with the same reference numerals as those in FIG. 13 may be briefly described or descriptions thereof may be omitted.

Referring to FIG. 14, an anti-reflection layer 235f of a cover window 130g according to still yet another embodiment of the present disclosure may include a flexible film 230H of a first refractive index and a flexible film 230L of a second refractive index. The flexible films 230H of the first refractive index and the flexible films 230L of the second refractive index may be alternately stacked on top of each other. A structure in which the flexible film 230H of the first refractive index and the flexible films 230L of the second refractive index are stacked on top of each other may be defined as a unit stack. In this regard, the unit stacks may be repeatedly vertically arranged to form the anti-reflection layer 235f. For example, the number of the unit stacks may be at least two.

The flexible film 230H of the first refractive index may include an organic material having a high refractive index in a range of 1.6 to 2.0. The flexible film 230L of the second refractive index may include an organic material having a low refractive index in a range of 1.2 to 1.4.

Each of the flexible film 230H of the first refractive index and the flexible film 230L of the second refractive index may include an organic material that has a relatively lower elastic modulus than that of the inorganic material, such that the flexibility of each of the flexible film 230H of the first refractive index and the flexible film 230L of the second refractive index is secured, and of each of the flexible film 230H of the first refractive index and the flexible film 230L of the second refractive index is easily stretched. For example, the organic material included in each of the flexible film 230H of the first refractive index and the flexible film 230L of the second refractive index may include the polymer compound containing the silicone-based polymer and the functional organic-inorganic silane compound.

The anti-reflection layer 235f has the multilayer structure in which the first refractive index flexible films 230H having the relatively high refractive index and the second refractive index flexible films 230L having the relatively low refractive index are alternately stacked on top of each other. Accordingly, the anti-reflection layer 235f may reduce the reflectance of the external light therefrom under a destructive interference effect that occurs during the interfacial reflection process.

Furthermore, the anti-reflection layer 235f may be composed only of the flexible films 230H and 230L. Thus, the stress applied to the cover window 130g may be prevented from increasing as folding or bending operations thereof are repeated, thereby preventing cracks from occurring therein.

Furthermore, the anti-reflection layer 235f may be composed only of the flexible films 230H and 230L, thereby improving the adhesion between the thin-films of the cover window 130g to prevent the delamination defect from occurring therein.

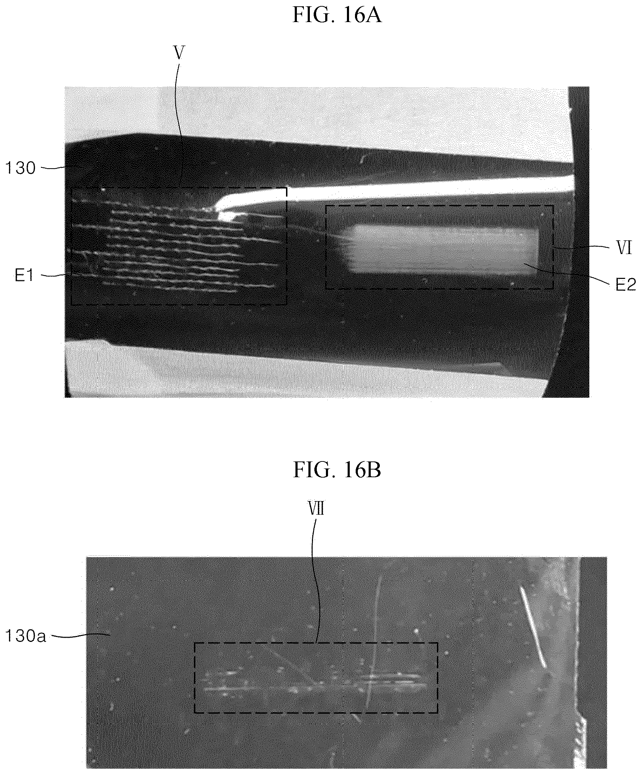

FIG. 15 is a table for illustrating durability of a cover window using a flexible film in accordance with the present disclosure. FIG. 16A and FIG. 16B are pictures for comparing surface strengths of a cover window based on anti-reflection layer coating schemes with each other.

A abrasion-resistance test may be carried out using a scheme in which a back-and-forth rubbing action of a abrasion-resistance test eraser is performed on and against the cover window and then a water contact angle relative thereto is measured. The higher the water contact angle (°) relative thereto, the lower the surface energy thereof. The water contact angle of 100° or greater is selected as a pass criterion on the abrasion-resistance test.

In this regard, when conducting the abrasion-resistance test, the cover window having the anti-reflection layer made only of an inorganic material on a base material as polymethyl methacrylate (PMMA) is used as Comparative Example, and the cover window incorporating the flexible film according to an embodiment of the present disclosure is used as Present Example.

Referring to FIG. 15, in Present Example in which the flexible film according to the present disclosure is introduced into the anti-reflection layer, the water contact angle relative thereto is similar to an initial water contact angle even after the abrasion-resistance test is performed 1000 to 3000 times. Thus, Present Example has excellent durability. On the other hand, in Comparative Example in which an anti-reflection layer made only of the inorganic material is introduced in the cover widow, the initial water contact angle relative thereto is 118.1°, but the water contact angle relative thereto is 70.3° after performing the abrasion-resistance test 1000 times. Accordingly, in Comparative Example in which an anti-reflection layer made only of the inorganic material is introduced in the cover widow, the durability thereof is reduced compared to Present Example in which the flexible reinforcing film is introduced into the anti-reflection layer.

Accordingly, when the flexible film including the organic material is introduced into the anti-reflection layer, the durability of the cover window may be improved and the abrasion-resistance may be improved.

The anti-reflection layer applied to the cover window according to the present disclosure may be formed by applying various coating schemes. Depending on the coating schemes thereof, the scratch resistance and the abrasion-resistance of the cover window may be improved or may be deteriorated.

For example, the anti-reflection layer including the flexible film including the organic material may be formed using a wet coating scheme or a dry coating scheme. The wet coating scheme may include spin coating or slit coating. The dry coating scheme may include E-beam deposition or sputtering deposition.

In this regard, forming the anti-reflection layer in the wet coating scheme has the advantage of high productivity. However, the anti-reflection layer formed in the wet coating scheme is vulnerable to wear, and the optical properties of the anti-reflection layer are poor, for example, the transmittance is lowered, and the reflectance is increased. In contrast thereto, when the anti-reflection layer is formed using the dry coating scheme, productivity may be relatively lower than that in the wet coating scheme. However, the anti-reflection layer formed in the dry coating scheme is durable against wear, and the optical properties of the anti-reflection layer are improved, for example, achieving low reflectance and high transmittance.

For example, referring to FIG. 16A which shows an anti-reflection layer including a flexible film including an organic material according to an embodiment of the present disclosure as formed using a spin coating scheme, based on results of the scratch resistance test and the abrasion-resistance test, it is identified that a defect E1 in which the cover window 130 is torn or pierced occurs, as shown in a 'V' area, or a haze E2 defect occurs on the cover window 130, as shown in a 'VI' area.

The scratch resistance test may be performed in a scheme in which using a hard test pencil, a friction is applied onto the cover window 130 including the anti-reflection layer and then a tear amount is measured. A hardness of the cover window 130 including the anti-reflection layer formed using the spin coating scheme may be lower than or equal to a pencil hardness 2H. The pencil hardness refers to a hardness of a surface of an object as measured relative to a hardness of the pencil lead. 9H is the highest pencil hardness value. The lower the hardness value, the softer the surface.

Accordingly, the cover window 130 including the anti-reflection layer formed using the spin coating scheme having the pencil hardness of 2H or lower does not protect the cover window from external impacts such that the defect E1 in which the cover window 130 is torn or pierced may occur as shown in a 'V' area.

In this regard, the anti-reflection layer including the flexible film according to an embodiment of the present disclosure may be formed in the dry coating scheme including an E-beam deposition or sputtering deposition scheme. The pencil hardness of the anti-reflection layer including the flexible film according to an embodiment of the present disclosure as formed in the dry coating scheme may be 3H or higher. For example, the pencil hardness of the anti-reflection layer including the flexible film according to an embodiment of the present disclosure may be 4H.

Referring to FIG. 16B which shows the results of the scratch resistance test and the abrasion-resistance test on the cover window 130a according to an embodiment of the present disclosure, it is identified that a defect in which the cover window 130 is torn or pierced does not occur the haze defect does not occur, as shown in a 'VII' area.

The cover window according to an embodiment of the present disclosure includes the anti-reflection layer including at least one layer made of the organic material, so that cracks may be prevented from occurring therein even when the cover window is repeatedly folded or rolled.

Furthermore, the anti-reflective film including the organic material layer may be included in the cover window, such that the surface hardness and scratch resistance thereof are excellent, and thus, external shocks applied to the cover window may be effectively blocked. Accordingly, the product reliability of the display device may be improved.

Furthermore, according to an embodiment of the present disclosure, the layers made of the inorganic material with a relatively high elastic modulus and the layers made of the organic material with a relatively low elastic modulus are stacked on top of each other to form the anti-reflective film. Thus, the number of layers stacked vertically to form the anti-reflection film may be reduced. Accordingly, a thickness of the anti-reflection film may be reduced, making it possible to implement a lightweight cover window, thereby reducing the overall weight of the display device.

## Claims

1. A cover window comprising:
a base substrate (200);
a hard coating layer (215) disposed on top of the base substrate (200);
an anti-reflection layer (235) disposed on top of the hard coating layer (215) and including a first coating layer (220) disposed on top of the hard coating layer (215) and a second coating layer (225) disposed on top of the first coating layer (220) and a flexible film (230),
wherein each of the first coating layer (220) and the second coating layer (225) includes a material having a relatively larger elastic modulus than an elastic modulus of the flexible film (230); and
an anti-fingerprint layer (240) disposed on top of the anti-reflection layer (235);
wherein the flexible film (230) is disposed under the anti-fingerprint layer (240), and constitutes a top layer of the anti-reflection layer (235).

2. The cover window of claim 1, wherein the flexible film (230) includes an organic material.

3. The cover window of claim 1 or 2, wherein one surface of the flexible film (230) is in contact with the hard coating layer (215).

4. The cover window of claim 2 or 3, wherein the organic material includes a polymer compound, preferably the polymer compound contains a silicone-based polymer and a functional organic-inorganic silane compound or the organic material includes a mixture of urethane and at least one of silane, low-concentration silane, high-concentration silane, or a silane compound.

5. The cover window of claim 1, wherein the first coating layer (220) includes an inorganic material having a low refractive index of 1.5 or lower, and/or
wherein the second coating layer (225) includes an inorganic material having a higher refractive index than the refractive index of the first coating layer (220).

6. The cover window of claim 1 or 5, wherein the anti-reflection layer (235) includes a stack structure in which the first coating layers (220) and the second coating layers (225) are alternately stacked on top of each other repeat.

7. The cover window of any one of claims 1, 5 or 6, wherein the flexible film (230) includes an organic material having a low refractive index lower than a refractive index of the second coating layer (225).

8. The cover window of any one of the preceding claims, wherein the anti-reflection layer (235) further includes:
a second coating layer (225) disposed under the flexible film (230) and including an inorganic material having a high refractive index; and
upper and lower first coating (220a, 220b) layers vertically spaced apart from each other and including an inorganic material having a low refractive index, wherein the second coating layer (225) is disposed between the upper and lower first coating layers (220a, 220b).

9. The cover window of claim 8, wherein the flexible film (230) is disposed under the anti-fingerprint layer (240) and includes an upper flexible film (230b) and a lower flexible film (230b), wherein the upper first coating layer (220a) is disposed between the upper flexible film (230b) and the lower flexible film (230a).

10. The cover window of any one of the preceding claims, wherein the anti-reflection layer (235) includes a stack in which the flexible films (230) and first coating layers (220a, 220b) are alternately stacked on top of each other repeat,
wherein a lowest flexible film (220a) among the flexible films (230a, 230b, 230c) contacts the hard coating layer (215),
wherein each of the first coating layers (220a, 220b) includes an inorganic material with a higher elastic modulus than an elastic modulus of each of the flexible films (230a, 230b, 230c).

11. The cover window of any one of the preceding claims 1-9, wherein the anti-reflection (235) layer includes a stack in which the flexible films (230) and second coating layers (225) are alternately stacked on top of each other,
wherein a lowest flexible film (230a) among the flexible films contacts the hard coating layer (215),
wherein each of the second coating layers (225) includes an inorganic material with a higher elastic modulus than an elastic modulus of each of the flexible films (230),
wherein the flexible film (230) includes an organic material having a refractive index lower than a refractive index of the second coating layer (225).

12. The cover window of any one of the preceding claims, wherein the flexible film (230) includes a flexible film stack in which first flexible films (230a) and second flexible films (230b) are alternately stacked on top of each other repeat,
wherein each of the first flexible films (230a) has a first refractive index, and each of the second flexible films (230b) has a second refractive index lower than the first refractive index.

13. A display device comprising:
a cover window (130) as claimed in any one of the preceding claims; and
a display panel (120) disposed under the cover window (130).

14. The display device of claim 13, wherein the anti-reflection layer (240) further includes a first coating layer disposed on top of the hard coating layer (215) and a second coating layer (225) disposed on top of the first coating layer (215),
wherein each of the first coating layer (220) and the second coating layer (225) includes an inorganic material,
wherein the flexible film (230) includes an organic material having a relatively lower elastic modulus than an elastic module of each of the first coating layer (220) and the second coating layer (225.

## Patentansprüche

1. Abdeckfenster, das Folgendes umfasst:
ein Grundsubstrat (200);
eine Hartbeschichtungsschicht (215), die auf dem Grundsubstrat (200) angeordnet ist;
eine Antireflexionsschicht (235), die auf der Hartbeschichtungsschicht (215) angeordnet ist und eine erste Beschichtungsschicht (220), die auf der Hartbeschichtungsschicht (215) angeordnet ist, und eine zweite Beschichtungsschicht (225), die auf der ersten Beschichtungsschicht (220) angeordnet ist, und einen flexiblen Film (230) enthält,
wobei die erste Beschichtungsschicht (220) und die zweite Beschichtungsschicht (225) jeweils ein Material enthalten, das einen relativ größeren Elastizitätsmodul als ein Elastizitätsmodul des flexiblen Films (230) aufweist; und
eine Antifingerabdruckschicht (240), die auf der Antireflexionsschicht (235) angeordnet ist;
wobei der flexible Film (230) unter der Antifingerabdruckschicht (240) angeordnet ist und eine oberste Schicht der Antireflexionsschicht (235) bildet.

2. Abdeckfenster nach Anspruch 1, wobei der flexible Film (230) ein organisches Material enthält.

3. Abdeckfenster nach Anspruch 1 oder 2, wobei sich eine Fläche des flexiblen Films (230) mit der Hartbeschichtungsschicht (215) in Kontakt befindet.

4. Abdeckfenster nach Anspruch 2 oder 3, wobei das organische Material eine Polymerverbindung enthält, wobei die Polymerverbindung vorzugsweise ein Polymer auf Basis von Silizium und eine funktionale organisch-anorganische Silan-Verbindung enthält oder das organische Material ein Gemisch aus Urethan und Silan und/oder Silan in geringer Konzentration und/oder Silan in hoher Konzentration und/oder einer Silan-Verbindung enthält.

5. Abdeckfenster nach Anspruch 1, wobei die erste Beschichtungsschicht (220) ein anorganisches Material mit einem niedrigen Brechungsindex von 1,5 oder niedriger enthält, und/oder
wobei die zweite Beschichtungsschicht (225) ein anorganisches Material mit einem höheren Brechungsindex als der Brechungsindex der ersten Beschichtungsschicht (220) enthält.

6. Abdeckfenster nach Anspruch 1 oder 5, wobei die Antireflexionsschicht eine Stapelstruktur enthält, in der die ersten Beschichtungsschichten (220) und die zweiten Beschichtungsschichten (225) wiederholt abwechselnd aufeinandergeschichtet sind.

7. Abdeckfenster nach einem der Ansprüche 1, 5 oder 6, wobei der flexible Film (230) ein organisches Material mit einem niedrigen Brechungsindex, der niedriger als ein Brechungsindex der zweiten Beschichtungsschicht (225) ist, enthält.

8. Abdeckfenster nach einem der vorhergehenden Ansprüche, wobei die Antireflexionsschicht (235) ferner Folgendes enthält:
eine zweite Beschichtungsschicht (225), die unter dem flexiblen Film (230) angeordnet ist und ein anorganisches Material mit einem hohen Brechungsindex enthält; und
eine obere und eine untere erste Beschichtungsschicht (220a, 220b), die vertikal voneinander beabstandet sind und ein anorganisches Material mit einem niedrigen Brechungsindex enthalten, wobei die zweite Beschichtungsschicht (225) zwischen der oberen und der unteren ersten Beschichtungsschicht (220a, 220b) angeordnet ist.

9. Abdeckfenster nach Anspruch 8, wobei der flexible Film (230) unter der Antifingerabdruckschicht (240) angeordnet ist und einen oberen flexiblen Film (230b) und einen unteren flexiblen Film (230b) enthält, wobei die obere erste Beschichtungsschicht (220a) zwischen dem oberen flexiblen Film (230b) und dem unteren flexiblen Film (230a) angeordnet ist.

10. Abdeckfenster nach einem der vorhergehenden Ansprüche, wobei die Antireflexionsschicht (235) einen Stapel enthält, in dem die flexiblen Filme (230) und die ersten Beschichtungsschichten (220a, 220b) wiederholt abwechselnd aufeinandergeschichtet sind,
wobei ein unterster flexibler Film (220a) von den flexiblen Filmen (230a, 203b, 230c) die Hartbeschichtungsschicht (215) berührt,
wobei jede der ersten Beschichtungsschichten (220a, 220b) ein anorganisches Material mit einem höheren Elastizitätsmodul als ein Elastizitätsmodul von jedem der flexiblen Filme (230a, 230b, 230c) enthält.

11. Abdeckfenster nach einem der vorhergehenden Ansprüche 1-9, wobei die Antireflexionsschicht (235) einen Stapel enthält, in dem die flexiblen Filme (230) und die zweiten Beschichtungsschichten (225) abwechselnd aufeinandergeschichtet sind,
wobei ein unterster flexibler Film (230a) von den flexiblen Filmen die Hartbeschichtungsschicht (215) berührt,
wobei die zweiten Beschichtungsschichten (225) jeweils ein anorganisches Material mit einem höheren Elastizitätsmodul als ein Elastizitätsmodul von jedem der flexiblen Filme (230) enthält,
wobei der flexible Film (230) ein organisches Material mit einem Brechungsindex der kleiner als ein Brechungsindex der zweiten Beschichtungsschicht (225) ist, enthält.

12. Abdeckfenster nach einem der vorhergehenden Ansprüche, wobei der flexible Film (230) einen Stapel flexibler Filme enthält, in dem erste flexible Filme (230a) und zweite flexible Filme (230b) wiederholt abwechselnd aufeinandergeschichtet sind,
wobei die ersten flexiblen Filme (230a) jeweils einen ersten Brechungsindex aufweisen und die zweiten flexiblen Filme (230b) jeweils einen zweiten Brechungsindex aufweisen, der niedriger als der erste Brechungsindex ist.

13. Anzeigevorrichtung, die Folgendes umfasst:
ein Abdeckfenster (130) nach einem der vorhergehenden Ansprüche, und
eine Anzeigetafel (120), die unter dem Abdeckfenster (130) angeordnet ist.

14. Anzeigevorrichtung nach Anspruch 13, wobei die Antireflexionsschicht (240) ferner eine erste Beschichtungsschicht, die auf der Hartbeschichtungsschicht (215) angeordnet ist, und eine zweite Beschichtungsschicht (225), die auf der ersten Beschichtungsschicht (215) angeordnet ist, enthält,
wobei die erste Beschichtungsschicht (220) und die zweite Beschichtungsschicht (225) jeweils ein anorganisches Material enthalten,
wobei der flexible Film (230) ein organisches Material mit einem relativ niedrigeren Elastizitätsmodul als ein Elastizitätsmodul der ersten Beschichtungsschicht (220) und der zweiten Beschichtungsschicht (225) enthält.

## Revendications

1. Vitre de recouvrement comportant :
un substrat de base (200) ;
une couche de revêtement dure (215) disposée au-dessus du substrat de base (200) ;
une couche antireflet (235) disposée au-dessus de la couche de revêtement dure (215) et incluant une première couche de revêtement (220) disposée au-dessus de la couche de revêtement dure (215) et une seconde couche de revêtement (225) disposée au-dessus de la première couche de revêtement (220), et un film souple (230),
dans laquelle chaque couche parmi la première couche de revêtement (220) et la seconde couche de revêtement (225) inclut un matériau présentant un module d'élasticité relativement plus élevé qu'un module d'élasticité du film souple (230) ; et
une couche anti-traces de doigt (240) disposée au-dessus de la couche antireflet (235) ;
dans laquelle le film souple (230) est disposé sous la couche anti-traces de doigts (240) et constitue une couche supérieure de la couche antireflet (235).

2. Vitre de recouvrement selon la revendication 1, dans laquelle le film souple (230) inclut un matériau organique.

3. Vitre de recouvrement selon la revendication 1 ou 2, dans laquelle une surface du film souple (230) est en contact avec la couche de revêtement dure (215).

4. Vitre de recouvrement selon la revendication 2 ou 3, dans laquelle le matériau organique inclut un composé polymère, le composé polymère contient de préférence un polymère à base de silicone et un composé silane organique-inorganique fonctionnel, ou le matériau organique inclut un mélange d'uréthane et d'au moins un élément parmi du silane, du silane à faible concentration, du silane à haute concentration ou un composé silane.

5. Vitre de recouvrement selon la revendication 1, dans laquelle la première couche de revêtement (220) inclut un matériau inorganique présentant un faible indice de réfraction égal à 1,5 ou moins, et/ou
dans laquelle la seconde couche de revêtement (225) inclut un matériau inorganique présentant un indice de réfraction supérieur à l'indice de réfraction de la première couche de revêtement (220).

6. Vitre de recouvrement selon la revendication 1 ou 5, dans laquelle la couche antireflet (235) inclut une structure d'empilement dans laquelle les premières couches de revêtement (220) et les secondes couches de revêtement (225) sont empilées les unes au-dessus des autres de manière alternée.

7. Vitre de recouvrement selon l'une quelconque des revendications 1, 5 ou 6, dans laquelle le film souple (230) inclut un matériau organique présentant un faible indice de réfraction inférieur à un indice de réfraction de la seconde couche de revêtement (225).

8. Vitre de recouvrement selon l'une quelconque des revendications précédentes, dans laquelle la couche antireflet (235) inclut en outre :
une seconde couche de revêtement (225) disposée sous le film souple (230) et incluant un matériau inorganique présentant un indice de réfraction élevé ; et
des premières couches de revêtement supérieure et inférieure (220a, 220b) verticalement espacées l'une de l'autre et incluant un matériau inorganique présentant un faible indice de réfraction, dans laquelle la seconde couche de revêtement (225) est disposée entre les premières couches de revêtement supérieure et inférieure (220a, 220b).

9. Vitre de recouvrement selon la revendication 8, dans laquelle le film souple (230) est disposé sous la couche anti-traces de doigt (240) et inclut un film souple supérieur (230b) et un film souple inférieur (230b), dans laquelle la première couche de revêtement supérieure (220a) est disposée entre le film souple supérieur (230b) et le film souple inférieur (230a).

10. Vitre de recouvrement selon l'une quelconque des revendications précédentes, dans laquelle la couche antireflet (235) inclut un empilement dans lequel les films souples (230) et des premières couches de revêtement (220a, 220b) sont empilés les uns au-dessus des autres de manière alternée et répétée,
dans laquelle un film souple le plus bas (220a) parmi les films souples (230a, 230b, 230c) est en contact avec la couche de revêtement dure (215),
dans laquelle chacune des premières couches de revêtement (220a, 220b) inclut un matériau inorganique présentant un module d'élasticité supérieur à un module d'élasticité de chacun des films souples (230a, 230b, 230c).

11. Vitre de recouvrement selon l'une quelconque des revendications 1 à 9 précédentes, dans laquelle la couche antireflet (235) inclut un empilement dans lequel les films souples (230) et des secondes couches de revêtement (225) sont empilés les uns au-dessus des autres de manière alternée,
dans laquelle un film souple le plus bas (230a) parmi les films souples est en contact avec la couche de revêtement dure (215),
dans laquelle chacune des secondes couches de revêtement (225) inclut un matériau inorganique présentant un module d'élasticité supérieur à un module d'élasticité de chacun des films souples (230),
dans laquelle le film souple (230) inclut un matériau organique présentant un indice de réfraction inférieur à un indice de réfraction de la seconde couche de revêtement (225).

12. Vitre de recouvrement selon l'une quelconque des revendications précédentes, dans laquelle le film souple (230) inclut un empilement de films souples dans lequel des premiers films souples (230a) et des seconds films souples (230b) sont empilés les uns au-dessus des autres de manière alternée et répétitive.
dans laquelle chacun des premiers films souples (230a) présente un premier indice de réfraction, et chacun des seconds films souples (230b) présente un second indice de réfraction inférieur au premier indice de réfraction.

13. Dispositif d'affichage comportant :
une vitre de recouvrement (130) selon l'une quelconque des revendications précédentes ; et
un panneau d'affichage (120) disposé sous la vitre de recouvrement (130).

14. Dispositif d'affichage selon la revendication 13, dans lequel la couche antireflet (240) inclut en outre une première couche de revêtement disposée au-dessus de la couche de revêtement dure (215) et une seconde couche de revêtement (225) disposée au-dessus de la première couche de revêtement (215),
dans lequel chaque couche parmi la première couche de revêtement (220) et la seconde couche de revêtement (225) inclut un matériau inorganique,
dans lequel le film souple (230) inclut un matériau organique présentant un module d'élasticité relativement moins élevé qu'un module d'élasticité de chaque couche parmi la première couche de revêtement (220) et la seconde couche de revêtement (225).
